# EUROPEAN PATENT SPECIFICATION

(11) **EP 0 319 066 B1**
(45) Date of publication and mention of the grant of the patent: **02.02.1994**
(21) Application number: 88202573.7
(22) Date of filing: 17.11.1988
(51) Int. Cl.: G11C 17/00, G11C 7/00

(54) **Bias and precharging circuit for a bit line of EPROM memory cells in CMOS technology**
Vorspannungs- und Vorladungsschaltung für eine Bitzeile mit EPROM-Speicherzellen in CMOS-Technologie
Circuit de polyrisation et de précharge pour une ligne de bit de cellules de mémoire EPROM en technologie CMOS

(30) Priority: 01.12.1987 IT 2282887
(43) Date of publication of application: 07.06.1989
(73) Proprietor: SGS-THOMSON MICROELECTRONICS s.r.l., 20041 Agrate Brianza (Milano) (IT)
(72) Inventor: Secol, Maurizio, I-20025 Legnano (Milano) (IT); Gaibotti, Maurizio, I-20030 Barlassina (Milano) (IT)
(74) Representative: Mittler, Enrico

(56) References cited:
- EP-A- 0 102 485
- US-A- 4 289 982

## Description

The subject of the present invention is a bit line bias and precharging circuit for reading EPROM memory cells in CMOS technology.

Known circuits of this type used for reading cells of an EPROM memory cell matrix comprise a part designed for bias of the bit line and a part designed for fast precharging of said bit line. There is also provided a sensing amplifier operating by comparison of the voltage of said bit line with that of a dummy bit line connected to comparison memory cells never subjected to programming.

Said circuits are based on the principle that bias originates in the bit line a voltage which depends on the state of conduction of the cell being read and is thus unbalanced with that of the dummy bit line. The unbalance is sensed by the sensing amplifier, which converts it into a reading signal indicating the state of the cell being read. Precharging makes reading fast.

The principal drawbacks of the abovesaid circuits are represented at present by high current consumption and the need for a very sensitive and hence rather complicated sensing amplifier which would be capable of sensing a rather small voltage unbalance at its ends.

EP-A-0 102 485 teaches the idea of switching off bit line active loads in a ROM to save power.

US-A-4 223 394 teaches the use of a cascode amplification stage for biasing a bit line.

WO 84/02800 teaches the use of two current sources for biasing sensing nodes coupled to a bit line and to a dummy bit line with the same current.

The object of the present invention is to realize a bit line bias and precharging circuit for reading EPROM memory cells in CMOS technology which is free from the aforesaid drawbacks and specifically provides very small current consumption and allows the use of a less sensitive and hence simpler sensing amplifier.

In accordance with the invention said object is achieved by a bit line bias and precharging circuit as defined in claim 1.

According to a preferred embodiment of the circuit in accordance with the invention the bias part comprises a cascode amplification stage placed on the bit line to amplify the voltage unbalance caused by bias of a cell at the input of the sensing amplifier.

Further in accordance with a preferred embodiment of the invention the bias part comprises current-mirror means placed between the bit line and the dummy bit line to cause said voltage unbalance.

As a result current consumption of the circuit is clearly reduced due to the effect of turning off the precharging and bias parts of the circuit at the end of the time strictly necessary for the sensing amplifier to read the state of the cell.

At the same time amplification of the voltage unbalance by the cascode stage and use of a current mirror allow use of a less sensitive and hence simpler sensing amplifier.

A preferred embodiment of the circuit in accordance with the invention is illustrated for greater clarity in the annexed drawing which shows the circuit diagram thereof.

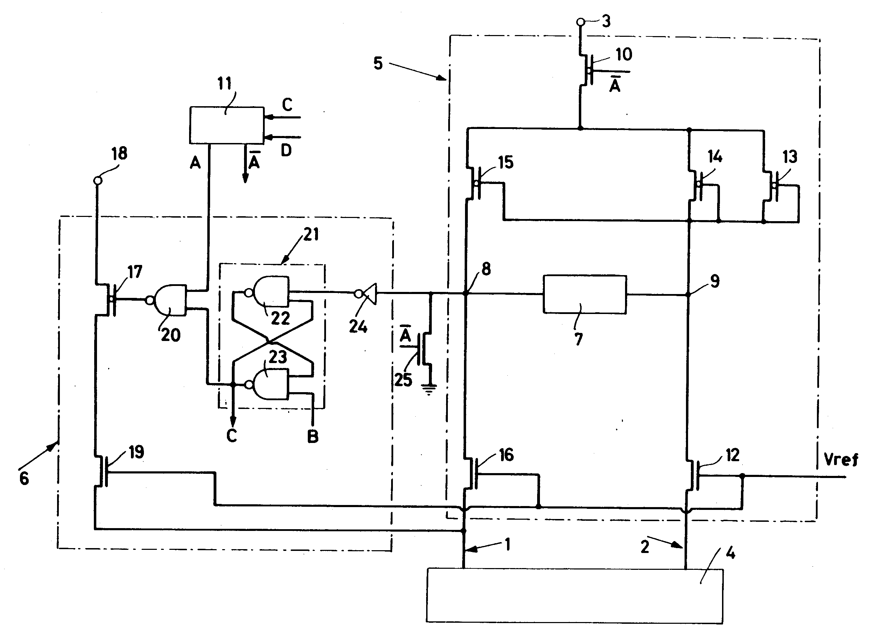

In the drawing reference numbers 1 and 2 indicate a bit line and a dummy bit line respectively which connect a voltage supply terminal 3 to an EPROM memory 4 with CMOS technology comprising in a known manner a matrix of memory cells selectable by means of a plurality of bit lines branching from the bit line 1 through a decoder and a plurality of word lines perpendicular to the bit lines as well as a plurality of comparison cells never subjected to programming to which is connected the dummy bit line 2.

With the lines 1 and 2 is associated a bias and precharging circuit made up of a bias part 5 and a fast precharging part 6. There is also provided a sensing amplifier 7 placed between respective intermediate circuit nodes 8 and 9 of the lines 1 and 2.

The bias part 5 is controlled through a P channel transistor 10 whose gate receives a control signal A̅ which constitutes the negation of a control signal A for the precharging part 6, both signals being emitted by an appropriately controlled generator 11.

Said bias part comprises on the dummy line 2 between the memory 4 and the circuit node 9 an N channel transistor 12 with gate controlled by a reference voltage Vref while between the circuit node 9 and the control transistor 10 are placed in parallel two equal P channel transistors 13 and 14 with gate terminals connected to respective drain terminals. To said transistors 13 and 14 corresponds on the line 1, in current mirror configuration, an equal P channel transistor 15 with gate terminal connected to the common gate and drain terminals of the transistors 13 and 14. Between the circuit node 8 and the memory 4, again on the bit line 1, there is placed an N channel transistor 16 controlled by the reference voltage Vref and constituting a cascode amplification stage for the voltage unbalance which occurs between the two lines 1 and 2 in the reading phase.

The precharging part 6 comprises a P channel control transistor 17 placed between a supply terminal 18 and the memory 4 with an N channel transistor 19 in series and controlled by the reference voltage Vref. The gate of the transistor 17 is controlled by the output of a NAND logic port 20 which receives at one input the abovementioned control signal A and has another input connected to the output of a flip-flop 21 made up of two NAND logic elements 22 and 23. One input of the logic element 22 is connected to the circuit node 8 through an inverter 24. One input of the logic element 23 receives an initialization signal B. The output of said logic element 23 forms a signal C which acts on the generator 11 in such a manner as to switch the signals A and A̅ to a logic level such as to turn off the precharging part 6 and the bias part 5 after reading by the sensing amplifier 7. An external reading signal D applied to the generator 11 is used to start precharging.

Between the circuit node 8 and ground there is placed an N channel transistor 25 with gate controlled by the signal A̅.

At rest, the output signal A of the generator 11 is at low level and the inverted output signal A̅ is at high level; the transistors 17 and 10 therefore are off and the transistor 25 is on, thus connecting the circuit node 8 and, through the transistor 16, the bit line 1 to ground.

When a cell reading operation is started, a reading signal D causes the generator 11 to bring the signal A to high level and the signal A̅ to low level; the transistors 17 and 10 therefore are turned on and the transistor 25 is turned off.

The transistor 10 provides the dummy bit line 2 with a first bias current and, therefore, with a first bias voltage at the circuit node 9, and further provides the bit line 1 with a second bias current and, therefore, with a second bias voltage at the circuit node 8. This second bias voltage depends on the programmed or non-programmed state of the cell being read, connected to the bit line 1. The sensing amplifier 7 compares the bias voltages at the nodes 8 and 9. The transistor 16 is, in usual way, an amplifier which amplifies the voltage unbalance at the inputs of the sensing amplifier 7.

The transistor 17 and, generally speaking, the precharging part 6 have the purpose of rapidly raising the bias voltage of the bit line 1. When the transistor 17 is turned on, a strong current is fed to the bit line 1, therefore raising the voltage at the node 8 to a precharge voltage value. The turning on of the transistor 15 causes said precharge voltage value to increase or decrease according to whether the memory cell being read is a programmed or virgin cell.

When the voltage at the node 8 reaches a high level precharge voltage value, the inverter 24 causes the flip-flop 21 to switch to a state in which the signal C causes the reset of the generator 11 to a state with the signal A at low level and the signal A̅ at high level. The transistors 17 and 15 are therefore turned off to reduce to zero the current consumption of the circuit after reading.

## Claims

1. A bit line bias and precharging circuit for an EPROM memory cell in CMOS technology arranged on a bit line (1), comprising a bias part (5) adapted to be connected to the bit line (1) and a precharging part (6) connected to the bias part (5) and adapted to be connected to the bit line (1), said bias part (5) including a sense amplifier (7) having a first input (9), a second input (8) and first switch means (10) activated in response to a reading signal (D) for feeding a first bias current to a dummy bit line (2) arranged in parallel with said bit line (1) to produce a first bias voltage at said first input (9) of the sense amplifier (7) and for feeding a second bias current to said bit line (1) to produce a second bias voltage depending on the state of the memory cell (4) being read at said second input (8) of the sense amplifier (7), characterized in that said precharging part (6) includes second switch means (17) activated in response to said reading signal (D) simultaneously with said first switch means (10) for connecting the bit line (1) to a voltage supply to precharge the bit line (1) at a precharge voltage value and means (24, 21, 20, 11) responsive to said precharge voltage value on said bit line (1) to cause deactivation of said first and second switch means (10, 17).

2. Circuit in accordance with claim 1 characterized in that said bias part (5) comprises a cascode amplification stage (16) placed on the bit line (1).

3. Circuit in accordance with claim 1 characterized in that said bias part (5) comprises current-mirror means (13, 14, 15) placed between the bit line (1) and the dummy bit line (2) to cause voltage unbalance between the two lines.

## Patentansprüche

1. Bitleitungs-Vorspann- und Vorladeschaltung für eine in CMOS-Technologie ausgeführte EPROM-Speicherzelle, die auf einer Bitleitung (1) angeordnet ist, umfassend einen Vorspannteil (5), der mit der Bitleitung (1) verbindbar ist, und einen Vorladeteil (6), der an den Vorspannteil (5) angeschlossen und mit der Bitleitung (1) verbindbar ist, wobei der Vorspannteil (5) einen Leseverstärker (7) mit einem ersten Eingang (9), einem zweiten Eingang (8) und eine erste Schalteinrichtung (10) aufweist, die ansprechend auf ein Lesesignal (D) aktiviert wird, um einer parallel zu der Bitleitung (1) angeordneten Dummy-Bitleitung (2) einen ersten Vorstrom zuzuführen, um an dem ersten Eingang (9) des Leseverstärkers (7) eine erste Vorspannung zu erzeugen, und um der Bitleitung (1) einen zweiten Vorstrom zuzuführen, um abhängig vom Zustand der gelesenen Speicherzelle (4) eine zweite Vorspannung am zweiten Eingang (8) des Leseverstärkers (7) zu erzeugen, dadurch gekennzeichnet, daß der Vorladeteil (6) eine zweite Schalteinrichtung (17) aufweist, die durch das Lesesignal (D) gleichzeitig mit der ersten Schalteinrichtung (10) aktiviert wird, um die Bitleitung (1) mit einer Spannungsversorgung zu verbinden und so die Bitleitung (1) auf einen Vorladespannungswert voraufzuladen, und eine Einrichtung (24, 21, 20, 11) enthält, die ansprechend auf den Vorladespannungswert auf der Bitleitung (1) eine Deaktivierung der ersten und der zweiten Schalteinrichtung (10, 17) veranlaßt.

2. Schaltung nach Anspruch 1, dadurch gekennzeichnet, daß der Vorspannteil (5) eine Kaskodeverstärkungsstufe (16) aufweist, die auf der Bitleitung (1) angeordnet ist.

3. Schaltung nach Anspruch 1, dadurch gekennzeichnet, daß der Vorspannteil (5) eine Stromspiegeleinrichtung (13, 14, 15) aufweist, die zwischen der Bitleitung (1) und der Dummy-Bitleitung (2) liegt, um zwischen den beiden Leitungen ein Spannungsungleichgewicht hervorzurufen.

## Revendications

1. Circuit de polarisation et de précharge de ligne de bit pour une cellule mémoire EPROM en technologie CMOS disposé sur une ligne de bit (1), comprenant une partie de polarisation (5) adaptée à être connectée à la ligne de bit (1) et une partie de précharge (6) connectée à la partie de polarisation (5) et adaptée à être connectée à la ligne de bit (1), la partie de la polarisation (5) comprenant un amplificateur de lecture (7) ayant une première entrée (9), une seconde entrée (8), et des premiers moyens de commutation (10) activés en réponse à un signal de lecture (D) pour fournir un premier courant de polarisation à une ligne de bit fantôme (2) disposée en parallèle avec la ligne de bit (1) pour produire une première tension de polarisation au niveau de la première entrée (9) de l'amplificateur de lecture (7) et pour fournir un second courant de polarisation à la ligne de bit (1) pour produire une seconde tension de polarisation qui dépend de l'état de la cellule mémoire (4) lue au niveau de la seconde entrée (8) de l'amplificateur de lecture (7), caractérisé en ce que la partie de précharge (6) comprend des seconds moyens de commutation (17) activés en réponse au signal de lecture (D), simultanément avec les premiers moyens de commutation (10), pour connecter la ligne de bit (1) à une alimentation de tension pour précharger la ligne de bit (1) à une valeur de tension de précharge et des moyens (24, 21, 20, 11) agissant en réponse à la valeur de tension de précharge sur la ligne de bit (1) pour provoquer une désactivation des premiers et seconds moyens de commutation (10, 17).

2. Circuit selon la revendication 1, caractérisé en ce que la partie de polarisation (5) comprend un étage amplificateur cascode (16) placé sur la ligne de bit (1).

3. Circuit selon la revendication 1, caractérisé en ce que la partie de polarisation (5) comprend un moyen de miroir de courant (13, 14, 15) placé entre la ligne de bit (1) et la ligne de bit fantôme (2) pour provoquer un déséquilibre de tension entre les deux lignes.
